# EUROPÄISCHE PATENTSCHRIFT

(11) **EP 1 276 151 B1**
(45) Veröffentlichungstag und Bekanntmachung des Hinweises auf die Patenterteilung: **12.07.2006**
(21) Anmeldenummer: 02011385.8
(22) Anmeldetag: 23.05.2002
(51) Int. Cl.: H01L 23/58, H01L 23/31

(54) **Gegen Analyse geschütztes Halbleiterbauelement und zugehöriges Herstellungsverfahren**
Semiconductor device protected against analysis and method of fabricating the same
Dispositif semiconducteur protégé contre l'analyse et sa méthode de fabrication

(30) Priorität: 27.06.2001 DE 10131014
(43) Veröffentlichungstag der Anmeldung: 15.01.2003
(73) Patentinhaber: Infineon Technologies AG, 81669 München (DE)
(72) Erfinder: Gundlach, Harald, 85354 Freising (DE); Marbach-Fischbach, Ida, 81829 München (DE)
(74) Vertreter: Epping - Hermann - Fischer

(56) Entgegenhaltungen:
- DE-A- 19 515 188
- GB-A- 2 223 355
- US-A- 3 725 671
- US-A- 3 875 431
- US-A- 3 882 323
- US-A- 5 710 203

## Beschreibung

Die vorliegende Erfindung bezieht sich auf ein Halbleiterbauelement mit einem Chip, der eine aktive Hauptseite mit Bauelementen und eine Unterseite, mit der der Chip mit einem Träger verbindbar ist, aufweist, wobei das Halbleiterbauelement darüber hinaus Mittel zum Deaktivieren des Chips bei einer Analyse oder einem Angriff aufweist.

Bei sicherheitsrelevanten Halbleiterbauelementen ist die Durchführung von Analysen und/oder Manipulationen der Chip-Schaltung unerwünscht, weil somit die Möglichkeit eines Mißbrauchs gegeben ist.

Als Beispiel hierfür seien die auf dem Pay-TV-Sektor zum Einsatz kommenden Chipkarten genannt. Gelingt es einem Hacker, die den Zugang zu einem bestimmten TV-Programm eröffnende Chipschaltung bezüglich der Lage und der Funktion einzelner Komponenten und/oder des Verlaufs der Leiterbahnen innerhalb des Chips zu analysieren und Möglichkeiten zu finden, diese durch geeignete Überbrückungen oder dergleichen zu manipulieren, so kann er dadurch in die Lage versetzt werden, einen kostenpflichtigen Service gratis zu benutzen.

Derartige Manipulationsmöglichkeiten sind nicht nur auf dem Pay-TV-Sektor, sondern bei allen Arten von zu Berechtigungskontrollen dienenden Chips von Bedeutung und eröffnen unzählige Mißbrauchsmöglichkeiten, welche nicht nur finanzielle Verluste, sondern auch ein erhebliches Sicherheitsrisiko zur Folge haben können.

Aus dem Stand der Technik ist eine Vielzahl an unterschiedlichen Möglichkeiten bekannt, wie eine Analyse und/oder Manipulation der Chip-Schaltung erschwert oder sogar unterbunden werden kann.

So ist aus der US 5,399,441 eine lichtundurchlässige Abdekkung für Halbleiterchips beschrieben, welche in einem Silikat-Vorstufen-Harz Metalle enthält, die bei einer Oxidation Wärme freisetzen. Durch die freigesetzte Wärme werden die darunterliegenden Chip-Bereiche derart beschädigt, daß eine bestimmungsgemäße Funktion nicht mehr möglich ist.

Aus der US 5,233,563 ist weiterhin eine Anordnung zum Schutz eines Halbleiterspeichers beschrieben, bei der im zu schützenden Chip elektrolytische Zellen vorgesehen sind, die bei Einwirken einer Säure, welche zum Wegätzen der Chipabdeckung üblicherweise eingesetzt wird, eine elektrische Spannung erzeugen, mit der gespeicherte Daten gelöscht werden können.

Die US 5,406,630 beschreibt eine Anordnung, bei der ober- und unterhalb des Chips streifen- oder gitterartige Sensoren angebracht sind, deren Zustand ständig überwacht wird. Bei Erfassen von Zuständen, beispielsweise eines Kurzschlusses oder einer Unterbrechung der Sensoranordnung, werden im Chip gespeicherte Daten durch eine entsprechende Schaltung gelöscht.

In der EP 0 510 433 A2 ist eine Halbleiteranordnung mit zwei Substraten beschrieben, bei der die Leiterzüge durch beide Substrate verlaufen. Bei einer Trennung der Substrate werden die Leiterzüge durchbrochen, so daß eine bestimmungsgemäße Funktion des zwischen den Substraten befindlichen Chips nicht mehr möglich ist.

Die DE 195 15 188 D2 beschreibt eine Chip-Abdeckung zur vollständigen oder teilweisen Abdeckung von Funktionskomponenten eines Chips, wobei die Chipabdeckung mit einem Aktivatorstoff versehen ist, der im aktivierten Zustand in der Lage ist, die elektrischen Funktionskomponenten des Chips ganz oder teilweise zu zerstören. Der Aktivatorstoff ist durch den Versuch, die Chip-Abdeckung vom Chip zu entfernen, aktivierbar. Der Aktivator ist dort ein Stoff, der beim Zusammentreffen mit einem die Chip-Abdeckung chemisch auflösenden Stoff in Form eines Lösungsmittels, eines Ätzmittels oder dergleichen aktiviert wird. Bei der Aktivierung wird eine Substanz mit reduzierender Wirkung freigesetzt, welche die üblicherweise aus Aluminium bestehenden Chip-Strukturen zerstört und somit eine Fremdanalyse oder Manipulation der sicherheitsrelevanten Chip-Bereiche unmöglich macht.

Die US 3,725,671 offenbart einen Schutzfilm, auf welchem der Chip aufgesetzt wird, der metall- und fluorhaltige Substanzen enthält, welche bei Aktivierung eine pyrotechnische Reaktion aufweisen. Durch die entstehende Wärme wird der Chip zerstört. Die Aktivierung erfolgt durch ein elektrisches Signal.

Aus dem Stand der Technik ist somit eine Vielzahl an Möglichkeiten bekannt, wie ein Chip gegen eine Analyse und/oder eine Manipulation geschützt werden kann. Die beschriebenen Schutzvarianten weisen vielfach den Nachteil auf, daß zu ihrer Realisierung gegenüber dem zu schützenden Chip ein großes BauVolumen benötigt wird. Die Schutzmechanismen sind vielfach in die Halbleiterchips umgebenden Gehäuse vorgesehen.

Beim Einbau eines gattungsgemäßen Halbleiterbauelementes in einen Chipkartenkörper steht jedoch nur wenig Raum für die Sicherungsmaßnahmen zur Verfügung. Das Problem besteht folglich darin, in dem vorgegebenen begrenzten Volumen, ausreichend viel Masse eines Aktivators, beispielsweise eines pyrotechnischen Materials, unterzubringen, damit die Energie-Entwicklung zur Zerstörung des zu schützenden Chips ausreichend ist. Bei zu geringen Massen beziehungsweise zu großen Oberflächen des Aktivators wird die Reaktions-Energie zu einem großen Teil nach außen abgeführt, wodurch eine Schädigung des Chips in nicht ausreichendem Maße oder überhaupt nicht eintritt. Für die Integration des Aktivators in ein Modul steht jedoch bei herkömmlichen Chip-Modulen nur eine Höhe von zirka 100 µm über dem zu schützenden Chip zur Verfügung.

Die Aufgabe der Erfindung besteht deshalb darin, ein Halbleiterbauelement anzugeben, welches gegen eine Analyse und/oder Manipulation geschützt ist und darüber hinaus zum Einbau in ein standardisiertes Chip-Modul geeignet ist. Darüber hinaus soll ein Herstellungsverfahren für das erfindungsgemäße Halbleiterbauelement angegeben werden.

Das erfindungsgemäße Halbleiterbauelement ist durch die Merkmale des vorliegenden Anspruches 1 beschrieben. Das zugehörige Herstellungsverfahren wird durch die Merkmale des Anspruches 13 definiert. Vorteilhafte Ausgestaltungen ergeben sich aus den jeweils abhängigen Ansprüchen.

Gemäß der Erfindung ist im Inneren des Chips ein Hohlraum vorgesehen, in welchem ein Aktivator eingelagert ist, der im Falle eines Angriffs eine mechanischbedingte, hitzebedingte oder chemischbedingte Zerstörung des Chips bewirkt.

Der Hohlraum ist vorzugsweise unterhalb der aktiven Hauptseite im Inneren des Chips gelegen. Für den Fall, daß dieser eine laterale Ausdehnung parallel zu der aktiven Hauptseite beziehungsweise der Unterseite des Chips aufweist, ist sichergestellt, daß ein großer Teil der Bauelemente auf der aktiven Hauptseite im Falle einer Aktivierung des Aktivators zerstört wird.

Der Sicherheitsmechanismus zur Deaktivierung beziehungsweise Zerstörung des Chips im Falle eines Angriffs und/oder einer Manipulation erfolgt somit im Gegensatz zu den Anordnungen aus dem Stand der Technik nicht außerhalb des Chips, sondern befindet sich im Inneren in unmittelbarer Nähe zu den sicherheitsrelevanten Funktionselementen. Dadurch, daß das Mittel zum Deaktivieren des Chips im Inneren desselben liegt, also vollständig vom Chipsubstrat umgeben ist, ist darüber hinaus sichergestellt, daß die bei einer Aktivierung entstehende Energie nicht in einen Bereich außerhalb des Chips abgeleitet werden kann.

Vorzugsweise ist der Hohlraum in einer vergrabenen Oxid-Schicht des Chips vorgesehen. Die Oxid-Schicht ist bevorzugt derart dotiert, daß eine Ätzung des Hohlraumes auf einfache Weise möglich und steuerbar ist. Die vergrabene Oxid-Schicht kann beispielsweise mit einem Ätzbeschleuniger, zum Beispiel mit Phosphor dotiert sein.

In einer weiteren Ausgestaltung der Erfindung ist vorgesehen, daß jeder Hohlraum über ein Zugangsloch von der Oberfläche des Chips zugänglich ist. Über dieses Zugangsloch, welches zunächst bis zu der vergrabenen Schicht reicht, wird der Hohlraum in die Oxid-Schicht geätzt. Das Zugangsloch selber kann später ebenfalls mit dem Aktivator gefüllt werden. Prinzipiell ist es unerheblich, von welcher Seite das Zugangsloch in Richtung des Hohlraumes angeordnet ist. Dies bedeutet, das Zugangsloch könnte von der Unterseite oder auch von der Chip-Seite bis zum jeweiligen Hohlraum angeordnet sein. Bevorzugt endet das Zugangsloch jedoch an der aktiven Hauptseite des Chips, da sich die Erzeugung des Hohlraumes somit auf einfache Weise in die Arbeitsschritte der Wafer-Prozessierung integrieren läßt.

Eine weitere Verbesserung gegen eine unerwünschte Analyse und/oder Manipulation wird dadurch erzielt, daß der in dem Hohlraum eingebrachte Aktivator zusätzlich auf der aktiven Hauptseite des Chips aufgebracht ist. Der Aktivator auf der Hauptseite und der Aktivator in dem Hohlraum können dann über den in dem Zugangsloch befindlichen Aktivator miteinander verbunden sein.

Der in den Hohlraum eingebrachte Aktivator beziehungsweise der auf der aktiven Hauptseite aufgebrachte Aktivator weist erfindungsgemäß Eigenschaften auf, die, angestoßen durch ein äußeres Ereignis, eine Explosion, ein Brennen oder ein Aufquellen des Stoffes bewirken. Das äußere Ereignis könnte beispielsweise im Abschleifen der den Chip üblicherweise umgebenden Abdeckung bestehen. Die bei einem Schleifvorgang wirkenden mechanischen Kräfte können dann zur Aktivierung des Aktivators verwendet werden. Der Aktivator kann auch andere chemische oder physikalische Reaktionen aufweisen, die den Chip im Falle eines Angriffs zumindest teilweise zerstören.

Um die Befüllung eines jeden Hohlraumes mit dem Aktivator zu erleichtern, ist in einer weiteren Ausgestaltung vorgesehen, daß zwischen jedem Hohlraum und der Oberfläche des Chips ein weiteres Zugangsloch vorgesehen ist, welches zur Entlüftung während des Befüllungsvorganges dient.

In einer Ausgestaltung ist der Chip mit seiner Rückseite auf einen Träger aufgesetzt und von einer Chipabdeckmasse umgeben. Alternativ kann der Chip "Flip-Chip", also mit seiner aktiven Hauptseite auf einen Träger aufgesetzt sein. In beiden Fällen ist das Halbleiterbauelement zum Einsetzen in eine Chipkarte geeignet. Der Träger kann in diesem Fall eine Leiterstruktur aufweisen, die mit entsprechenden Kontakten des Chips verbunden ist.

Das erfindungsgemäße Verfahren zum Herstellen des oben beschriebenen Halbleiterbauelementes umfaßt die nachfolgenden Schritte: Im Rahmen der Prozessierung des Wafers wird eine vergrabene Oxid-Schicht erzeugt. In einem nächsten Schritt werden die Bauelemente auf der aktiven Hauptseite des Chips erzeugt. Von der Oberfläche des Chips her wird in einem nächsten Verfahrensschritt wenigstens ein Zugangsloch bis zu der vergrabenen Oxid-Schicht hergestellt. Anschließend findet eine Ausätzung der vergrabenen Oxid-Schicht durch das Zugangsloch statt, wobei der Ätzvorgang abgebrochen wird, wenn der entstandene Hohlraum ein ausreichendes Volumen für den einzubringenden Aktivator aufweist. Im letzten Schritt wird der im Falle einer äußeren Einwirkung die mechanische Zerstörung des Chips bewirkende Aktivator in den Hohlraum eingebracht.

In einer Fortbildung des erfindungsgemäßen Herstellungsverfahrens wird die Wand des Zugangslochs vor der Ausätzung der vergrabenen Oxid-Schicht mit einem ätzresistenten Stoff ausgekleidet.

Sofern auch auf die aktive Hauptseite des Chips der Aktivator aufgebracht werden soll, ist es vorteilhaft, wenn die aktive Hauptseite ebenfalls mit dem ätzresistenten Stoff versehen wird.

Ausführungsbeispiele der Erfindung werden nachfolgend unter Bezugnahme auf die Figuren näher erläutert. Es zeigen:
- Figur 1: ein erstes Ausführungsbeispiel des erfindungsgemäßen Halbleiterbauelementes und
- Figur 2: ein zweites Ausführungsbeispiel des erfindungsgemäßen Halbleiterbauelementes.

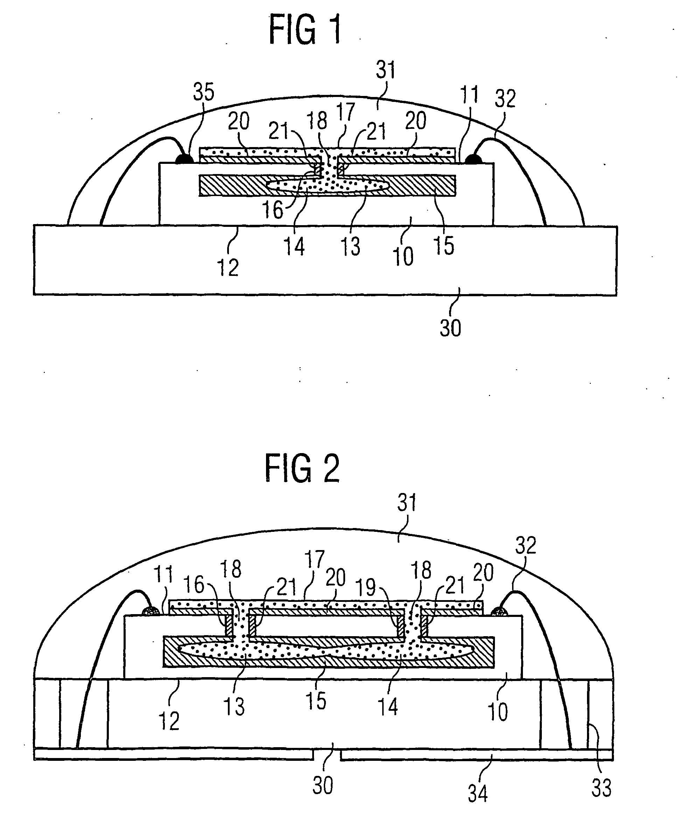

Figur 1 zeigt ein erstes Ausführungsbeispiel der erfindungsgemäßen Halbleiteranordnung. Ein Chip 10 ist mit seiner Unterseite 12 auf einen Träger 30 montiert. Der Träger 30 kann eine Leiterplatte oder ein flexibles Substrat sein, welches seinerseits zum Beispiel in eine Chipkarte eingebracht wird. Auf der von dem Träger 30 abgewandten Hauptseite 11, der aktiven Hauptseite, weist der Chip 10 in bekannter Weise Bauelemente auf. Diese befinden sich, wie üblich, in unmittelbarer Nähe zur aktiven Hauptseite 11 und sind elektrisch mit Kontaktpads 35 auf der aktiven Hauptseite 11 elektrisch verbunden. Die Kontaktpads 35 ihrerseits sind über Bonddrähte 32 mit einer Leiterstruktur auf dem Träger 30 verbunden. Die elektrische Verbindung des Chips 10 mit dem Träger könnte auch flip-chip, also mit der aktiven Seite voran mit entsprechenden Kontakten des Trägers erfolgen.

Erfindungsgemäß ist der Sicherungsmechanismus gegen eine Analyse und/oder Manipulation zumindest im Inneren des Chips 10 gelegen. Unterhalb der Bauelemente der aktiven Hauptseite 11 befindet sich eine vergrabene Oxid-Schicht 15. In dieser Oxid-Schicht 15 ist zumindest ein Hohlraum 13 durch Ätzen ausgebildet worden. Das Ätzmittel wird dabei durch ein Zugangsloch 16, welches sich zwischen der Oxid-Schicht 15 und der aktiven Hauptseite 11 erstreckt, eingebracht. Als Ätzmittel kann beispielsweise eine konzentrierte HF-Lösung verwendet werden. Damit durch das Ätzmittel nicht auch Bereiche der aktiven Hauptseite 11 angegriffen werden, sind die Wände des Zugangslochs 16 mit einer ätzresistenten Schicht 21 bedeckt. Diese erstreckt sich im Beispiel ebenfalls auf der aktiven Hauptseite 11. Die ätzresistente Schicht 20, 21 besteht beispielsweise aus Silizium-Nitrid. Somit ist es auch möglich, den Aktivator auf dem Chip selber aufzubringen. Der an der Oberfläche liegende Aktivator ist mit 17 bezeichnet, während der ebenfalls in dem Zugangsloch 16 befindliche Aktivator das Bezugszeichen 18 trägt. Der Aktivator 17 kann sich über die gesamte Oberfläche des Chips 11 erstrecken, wobei lediglich die Kontaktpads 35 ausgespart zu werden brauchen. Der Hohlraum ist in ein zirka 170 µm hohes Chip-Substrat 10 eingebracht. Die Höhe des Hohlraumes 13 beträgt dabei zirka 100 µm. Die auf der aktiven Hauptseite 11 aufgebrachte Aktivatorschicht 17 beträgt ebenfalls zirka 100 µm.

Das Ätzen eines Hohlraumes 13 in der vergrabenen Oxid-Schicht 15 wird abgebrochen, wenn ein Hohlraum 13 eine ausreichende Größe zur Aufnahme des Aktivators 14 aufweist. Vorzugsweise erstreckt sich der Hohlraum 13 lateral parallel zu der aktiven Hauptseite 11 beziehungsweise zu der Unterseite 12. Ein besonders guter Schutz wird dann erreicht, wenn ein möglichst großer Bereich der Chipfläche mit einem oder mehreren der oben beschriebenen Hohlräume versehen ist.

Das Befüllen eines Hohlraumes 13 mit dem Aktivator wird dadurch erleichtert, daß ein weiteres Zugangsloch 19 zwischen der vergrabenen Oxid-Schicht 15 und der Oberfläche, zum Beispiel der aktiven Hauptseite 11, vorgesehen wird. Das Ätzen des Hohlraumes kann dann von beiden Zugangslöchern her erfolgen. Das Einfüllen des Aktivators geschieht lediglich durch ein Zugangsloch, so daß eine Entlüftung über das weitere Zugangsloch 19 möglich ist. Nachdem der Hohlraum vollständig mit dem Aktivator gefüllt ist, kann auch das weitere Zugangsloch mit einem Aktivator aufgefüllt werden. Dies ist beispielsweise in der vorliegenden Figur 2 dargestellt.

Das Ausführungsbeispiel gemäß der vorliegenden Figur 2 unterscheidet sich von der Figur 1 weiterhin durch die Ausgestaltung des Trägers 30. Dieser weist in bekannter Weise Ausnehmungen 33 auf. Auf der dem Chip gegenüberliegenden Hauptseite des Trägers 30 befindet sich eine Leiterstruktur. Die Kontaktpads 35 sind dabei mittels Bonddrähten 32 durch die Ausnehmungen 33 hindurch mit der Leiterstruktur 34 elektrisch miteinander verbunden. Ein derart ausgebildetes Halbleiterbauelement ist somit als Chip-Modul ausgebildet und kann in bekannter Weise in den Körper einer Chipkarte eingesetzt werden.

Der Aktivator 14, 17 und 18 weist physikalische und chemische Eigenschaften auf, so daß er nach einem äußeren Ereignis zum Brennen, Explodieren oder Aufquellen gebracht wird. Dadurch, daß ein großer Teil des Aktivators im Inneren des Chip-Körpers gelegen ist, steht die bei der Reaktion entstehende Energie vollständig zur Zerstörung des Chips zur Verfügung. Darüber hinaus ist der vorgeschlagene Sicherheitsmechanismus äußerst platzsparend. Der Aktivator kann beispielsweise aus Materialien bestehen, wie sie in der US 3,725,671 beschrieben sind. Bevorzugt weist der Aktivator somit Materialien der Gruppe der Perflourpolymere mit hohem Flourgehalt auf.

Das äußere Ereignis, das den Aktivator zur Reaktion bringt, könnte beispielsweise ein Schleifvorgang der Aktivatorschicht 17 sein. Beinhaltet der Aktivator beispielsweise grobe, harte Körner, so kann dieser als Zünder für die chemische Substanz dienen. Die Wirkung des Aktivators im Hohlraum wird dadurch verstärkt, daß die bei einem Schleifvorgang von außen wirkende Kraft zu einem Eindrücken des Hohlraums verwendet wird. Hierbei werden in die Aktivatorschicht 17 gekörnte Materialien eingebracht, die das Eindrücken verstärken. Besteht der Aktivator aus einem pyrotechnischen Material, so könnte die Zündung einsetzen, wenn der Aktivator 17 mit einer Säure in Kontakt kommt, welche zum Abtragen der Chipabdeckung 31 sowie der auf dem Chip befindlichen Schichten verwendet wird. Bei der Zündung der Aktivatorschicht 17 wird dann auch das in dem Hohlraum 13 befindliche Material 14 aktiviert.

Ein Vorteil des erfindungsgemäßen Bauelementes besteht darin, daß dieses trotz eines sehr effektiven Sicherungsmechanismusses gegenüber konventionellen Chips keinen größeren Platzbedarf benötigt. Darüber hinaus läßt sich das erfindungsgemäße Halbleiterbauelement auf einfache Weise herstellen.

Vor der Prozessierung der aktiven Bauelemente wird auf Waferebene eine vergrabene Oxid-Schicht in dem Chipsubstrat erzeugt. Vorzugsweise wird die vergrabene Oxid-Schicht mit einem Ätzbeschleuniger, zum Beispiel Phosphor, dotiert. Im nächsten Schritt werden - ebenfalls auf Waferebene - die aktiven Bauelemente benachbart der aktiven Hauptseite erzeugt. Anschließend werden, vorzugsweise von der aktiven Hauptseite her, Zugangslöcher von der Oberfläche bis zu der vergrabenen Oxid-Schicht erzeugt. Die Wände der Zugangslöcher sowie die aktive Hauptseite des Chips werden mit einem ätzresistenten Stoff, zum Beispiel Silizium-Nitrid, ausgekleidet. Wichtig ist dabei, daß der Bodenbereich eines jeden Zugangslochs frei bleibt. Durch die Zugangslöcher wird ein Ätzmittel eingebracht, welches in der vergrabenen Oxid-Schicht die Hohlräume ausätzt. Als Ätzmittel kommt eine konzentrierte HF-Lösung in Betracht. Der Ätzvorgang wird abgebrochen, sobald die Hohlräume ausreichend groß sind und eine Menge des Aktivators eingebracht werden kann, die ausreichend ist, um im Falle einer Aktivierung die Bauelemente des Chips zu zerstören. Die laterale Ausdehnung der Hohlräume, wie sie in einem flachen Chipsubstrat erforderlich ist, läßt sich dabei durch eine Richtungsselektivität des Ätzens von bis zu 1:100 erreichen.

### Bezugszeichenliste

- 10: Chip
- 11: Aktive Hauptseite
- 12: Unterseite
- 13: Hohlraum
- 14: Aktivator
- 15: Oxid-Schicht
- 16: Zugangsloch
- 17: Aktivator
- 18: Aktivator
- 19: Zugangsloch
- 20: Ätzresistente Schicht
- 21: Ätzresistente Schicht
- 30: Träger
- 31: Chipabdeckmasse
- 32: Bonddraht
- 33: Ausnehmung
- 34: Leiterstruktur

## Patentansprüche

1. Halbleiterbauelement mit einem Chip (10), der eine aktive Hauptseite (11) mit Bauelementen und eine Unterseite (12), mit der der Chip (10) mit einem Träger (30) verbindbar ist, aufweist, wobei das Halbleiterbauelement Mittel zum Deaktivieren des Chips (10) bei einem Angriff aufweist, das ein Aktivator umfasst, der im Falle eines Angriffs eine Zerstörung des Chips (10) bewirkt
**dadurch gekennzeichnet, daß**
das Mittel (13, 14) zum Deaktivieren des Chips mindestens einen Hohlraum (13) in dem Chip (10) umfasst, in welchen der Aktivator (14) eingelagert ist.

2. Halbleiterbauelement nach Anspruch 1,
**dadurch gekennzeichnet, daß**
der Hohlraum (13) unterhalb der aktiven Hauptseite (11) im Inneren des Chips (10) gelegen ist.

3. Halbleiterbauelement nach Anspruch 1 oder 2,
**dadurch gekennzeichnet, daß**
der Hohlraum (13) eine laterale Ausdehnung parallel zu der aktiven Hauptseite (11) bzw. der Unterseite (12) des Chips (10) aufweist.

4. Halbleiterbauelement nach einem der Ansprüche 1 bis 3,
**dadurch gekennzeichnet, daß**
der Hohlraum (13) in einer vergrabenen Oxid-Schicht (15) des Chips (10) vorgesehen ist.

5. Halbleiterbauelement nach Anspruch 4,
**dadurch gekennzeichnet, daß**
die Oxid-Schicht (15) derart dotiert ist, daß eine Ätzung beschleunigt werden kann.

6. Halbleiterbauelement nach einem der Ansprüche 1 bis 5,
**dadurch gekennzeichnet, daß**
jeder Hohlraum (13) über ein Zugangsloch (16) von der Oberfläche des Chips (10) zugänglich ist.

7. Halbleiterbauelement nach Anspruch 6,
**dadurch gekennzeichnet, daß**
das Zugangsloch (16) an der aktiven Hauptseite (11) des Chips (10) endet.

8. Halbleiterbauelement nach einem der Ansprüche 1 bis 7,
**dadurch gekennzeichnet, daß**
der in dem Hohlraum (13) eingebrachte Aktivator (14) zusätzlich auf der aktiven Hauptseite (11) des Chips (10) aufgebracht ist.

9. Halbleiterbauelement nach einem der Ansprüche 1 bis 8,
**dadurch gekennzeichnet, daß**
der in den Hohlraum (13) eingebrachte Aktivator (14) bzw. der auf der aktiven Hauptseit aufgebrachte Aktivator (17) Eigenschaften aufweist, die, angestoßen durch ein äußeres Ereignis, eine Explosion, ein Brennen oder ein Aufquellen des Stoffes (13, 15) bewirken.

10. Halbleiterbauelement nach einem der Ansprüche 6 bis 9,
**dadurch gekennzeichnet, daß**
ein weiteres Zugangsloch (19) zwischen jedem Hohlraum (13) und der Oberfläche des Chips (10) vorgesehen ist, das zur Entlüftung eines jeden Hohlraumes (13) bei der Befüllung mit dem Aktivator (14) dient.

11. Halbleiterbauelement nach einem der Ansprüche 1 bis 10,
**dadurch gekennzeichnet, daß**
der Chip (10) mit seiner unter Seite (12) auf einen Träger (30) aufgesetzt ist und von einer Chipabdeckmasse (31) umgeben ist und das Halbleiterbauelement zum Einsetzen in eine Chipkarte vorgesehen ist.

12. Halbleiterbauelement nach einem der Ansprüche 1 bis 10,
**dadurch gekennzeichnet, daß**
der Chip (10) mit seiner aktiven Hauptseite (11) auf einen Träger (30) aufgesetzt ist, und das Halbleiterbauelement zum Einsetzen in eine Chipkarte vorgesehen ist.

13. Verfahren zum Herstellen eines Halbleiterbauelementes nach einem der Ansprüche 1 bis 11,
**dadurch gekennzeichnet, daß**
- im Rahmen der Prozessierung eines Wafers eine vergrabene Oxid-Schicht (15) erzeugt wird,
- die Bauelemente auf der aktiven Hauptseite (11) erzeugt werden,
- von der Oberfläche des Chips (11) her ein Zugangsloch (16) bis zu der vergrabenen Oxid-Schicht (15) erzeugt wird,
- die Wand des Zugangslochs (16) mit einem ätzresistenten Stoff (21) ausgekleidet wird,
- eine Ausätzung der vergrabenen Oxid-Schicht (15) durch das Zugangsloch (16) erfolgt, wobei der Ätzvorgang abgebrochen wird, wenn der Hohlraum ein ausreiches Volumen für den einzubringenden Aktivator (14) aufweist, und
- der im Falle einer äußeren Einwirkung die mechanische Zerstörung des Chips (10) bewirkende Aktivator (14) eingebracht wird.

14. Verfahren nach Anspruch 13,
**dadurch gekennzeichnet, daß**
die aktive Hauptseite (11) mit dem ätzresisten Stoff (20) versehen wird und der im Falle einer äußeren Einwirkung die mechanische Zerstörung des Chips (10) bewirkende Aktivator (14) auch auf die aktive Hauptseite (11) des Chips aufgebracht wird.

## Claims

1. Semiconductor device having a chip (10), which has an active main side (11) with devices and an underside (12), by which the chip (10) can be connected to a carrier (30), the semiconductor device having means for deactivating the chip (10) in the event of an attack, said means comprising an activator which brings about a destruction of the chip (10) in the case of an attack,
**characterized in that**
the means (13, 14) for deactivating the chip comprises at least one cavity (13) in the chip (10) into which the activator (14) is incorporated.

2. Semiconductor device according to Claim 1,
**characterized in that**
the cavity (13) is located below the active main side (11) in the interior of the chip (10).

3. Semiconductor device according to Claim 1 or 2,
**characterized in that**
the cavity (13) has a lateral extent parallel to the active main side (11) or the underside (12) of the chip (10).

4. Semiconductor device according to one of Claims 1 to 3,
**characterized in that**
the cavity (13) is provided in a buried oxide layer (15) of the chip (10).

5. Semiconductor device according to Claim 4,
**characterized in that**
the oxide layer (15) is doped in such a way that an etch can be accelerated.

6. Semiconductor device according to one of Claims 1 to 5,
**characterized in that**
each cavity (13) is accessible from the surface of the chip (10) via an access hole (16).

7. Semiconductor device according to Claim 6,
**characterized in that**
the access hole (16) ends at the active main side (11) of the chip (10).

8. Semiconductor device according to one of Claims 1 to 7,
**characterized in that**
the activator (14) introduced in the cavity (13) is additionally applied on the active main side (11) of the chip (10).

9. Semiconductor device according to one of Claims 1 to 8,
**characterized in that**
the activator (14) introduced into the cavity (13) or the activator (17) applied on the active main side has properties which, instigated by an external event, effect an explosion, a combustion or a swelling of the substance (13, 15).

10. Semiconductor device according to one of Claims 6 to 9,
**characterized in that**
a further access hole (19) is provided between each cavity (13) and the surface of the chip (10), which hole serves for ventilating each cavity (13) in the course of filling with the activator (14).

11. Semiconductor device according to one of Claims 1 to 10,
**characterized in that**
the chip (10) is placed by its underside (12) onto a carrier (30) and is surrounded by a chip covering composition (31) and the semiconductor device is provided for insertion into a smart card.

12. Semiconductor device according to one of Claims 1 to 10,
**characterized in that**
the chip (10) is placed by its active main side (11) onto a carrier (30), and the semiconductor device is provided for insertion into a smart card.

13. Method for fabricating a semiconductor device according to one of Claims 1 to 11,
**characterized in that**
- a buried oxide layer (15) is produced in the context of the processing of a wafer,
- the devices are produced on the active main side (11),
- an access hole (16) is produced from the surface of the chip (11) as far as the buried oxide layer (15),
- the wall of the access hole (16) is lined with an etching-resistant substance (21),
- the buried oxide layer (15) is etched out through the access hole (16), the etching operation being terminated when the cavity has a sufficient volume for the activator (14) to be introduced,
- the activator (14), which effects the mechanical destruction of the chip (10) in the case of an external influence, is introduced.

14. Method according to Claim 13,
**characterized in that**
the active main side (11) is provided with the etching-resistant substance (20) and the activator (14), which effects the mechanical destruction of the chip (10) in the case of an external influence, is also applied to the active main side (11) of the chip.

## Revendications

1. Composant à semi-conducteur comprenant une puce (10) qui a une face (11) principale active ayant des composants et une face (12) inférieure par laquelle la puce (10) peut être reliée à un support (30), le composant à semi-conducteur ayant un moyen, comprenant un activateur, de désactivation de la puce (10) s'il se produit une attaque qui, dans le cas d'une attaque, provoque une destruction de la puce (10), **caractérisé en ce que** le moyen (13, 14) de désactivation de la puce comprend au moins une cavité (13) dans la puce (10) dans laquelle l'activateur (14) est logé.

2. Composant à semi-conducteur suivant la revendication 1, **caractérisé en ce que** la cavité (13) est en dessous de la face (11) principale active à l'intérieur de la puce (10).

3. Composant à semi-conducteur suivant la revendication 1 ou 2, **caractérisé en ce que** la cavité (13) a une étendue latérale parallèlement à la face (11) principale active ou à la face (12) inférieure de la puce (10).

4. Composant à semi-conducteur suivant l'une des revendications 1 à 3, **caractérisé en ce que** la cavité (13) est prévue dans une couche (15) d'oxyde enterrée de la puce (10).

5. Composant à semi-conducteur suivant la revendication 4, **caractérisé en ce que** la couche (15) d'oxyde est dopée, de manière à pouvoir accélérer une attaque.

6. Composant à semi-conducteur suivant l'une des revendications 1 à 5, **caractérisé en ce que** chaque cavité (13) est accessible par un trou (16) d'accès de la surface de la puce (10).

7. Composant à semi-conducteur suivant la revendication 6, **caractérisé en ce que** le trou (16) d'accès se termine sur la face (11) principale active de la puce (10).

8. Composant à semi-conducteur suivant l'une des revendications 1 à 7, **caractérisé en ce que** l'activateur (14) introduit dans la cavité (13) est appliqué, en outre, sur la face (11) principale active de la puce (10).

9. Composant à semi-conducteur suivant l'une des revendications 1 à 8, **caractérisé en ce que** l'activateur (14) introduit dans la cavité (13) ou l'activateur (17) appliqué sur la face principale active a des propriétés qui provoquent, sous l'effet d'un événement extérieur, une explosion, une combustion ou un gonflement de la matière (13, 15).

10. Composant à semi-conducteur suivant l'une des revendications 6 à 9, **caractérisé en ce qu'**il est prévu entre chaque cavité (13) et la surface de la puce (10) un autre trou (19) d'accès qui sert à enlever l'air de chaque cavité (13) lorsqu'on la remplit de l'activateur (14).

11. Composant à semi-conducteur suivant l'une des revendications 1 à 10, **caractérisé en ce que** la puce (10) est posée par sa face (12) inférieure sur un support (30) et est entourée d'une composition (31) de recouvrement de puce, et le composant à semi-conducteur est destiné à être inséré dans une carte à puce.

12. Composant à semi-conducteur suivant l'une des revendications 1 à 10, **caractérisé en ce que** la puce (10) est posée par sa face (11) principale active sur un support (30) et le composant à semi-conducteur est prévu pour être inséré dans une carte à puce.

13. Procédé de production d'un composant à semi-conducteur suivant l'une des revendications 1 à 11, **caractérisé en ce que**
- on produit, dans le cadre du traitement d'une tranche, une couche (15) d'oxyde enterrée,
- on produit les composants sur la face (11) principale active,
- on produit à partir de la surface de la puce (11) un trou (16) d'accès allant jusqu'à la couche (15) d'oxyde enterrée,
- on revêt la paroi du trou (16) d'accès d'une substance (21) résistant à l'attaque,
- on effectue une attaque de la couche (15) d'oxyde enterrée en passant par le trou (16) d'accès, l'opération d'attaque étant interrompue lorsque la cavité a un volume suffisant pour l'activateur (14) à introduire, et
- on introduit l'activateur (14) provoquant, dans le cas d'une action extérieure, la destruction mécanique de la puce (10).

14. Procédé suivant la revendication 13, **caractérisé en ce que** l'on munit la face (11) principale active d'une substance (20) résistant à l'attaque et on met aussi sur la face (11) principale active de la puce l'activateur (14) provoquant, dans le cas d'une action extérieure, la destruction mécanique de la puce (10).
